# EUROPEAN PATENT APPLICATION

(11) **EP 4 625 485 A2**
(43) Date of publication of application: **01.10.2025**
(21) Application number: 24217387.0
(22) Date of filing: 04.12.2024
(51) Int. Cl.: H01L 23/00

(54) **METHODS AND ARCHITECTURES FOR HYBRID SOLDER AND SOLDERLESS DIE STACKING**

(30) Priority: 11.12.2023 US 202318535808
(71) Applicant: INTEL Corporation, Santa Clara, CA 95054 (US)
(72) Inventor: VAIDYA, Adiya Surendra, Gilbert, 85298 (US); KARHADE, Omkar G., Chandler, 85248 (US); COLLINS, Andrew P., Chandler, 85249 (US); JIANG, Zhenguo, Chandler, 85249 (US); VALAVALA, Krishna Vasanth, Chandler, 85226 (US)
(74) Representative: 2SPL Patentanwälte PartG mbB

(57) **Abstract**

Methods and architectures for hybrid solder and solderless die stacking. Devices include a semiconductor die that is solderless bonded (using hybrid bonding interconnect (HBI) technology) at a bottom surface to a base die. The semiconductor die includes a region with through silicon vias (TSVs) exposed at an upper surface. The semiconductor die and the TSVs are configured to have a solder-attach component, such as a DRAM or high bandwidth memory (HBM), attached thereto. The solder-attach component is stacked on the semiconductor die and soldered to the semiconductor die at the TSVs.

## Description

### BACKGROUND

When a large die is disaggregated into smaller chiplets for yield (or other) reasons, there is a need to connect them together with high wiring density so that functionally they act like a single monolithic die. One of the important factors determining wiring density is the minimum distance between bumps referred to as an interconnect pitch. To advance Moore's law, the interconnect pitch has to scale, and the solder-based interconnects or solder-attach process begins to experience technical problems in the form of failures and faults below about a 25µm pitch. Hybrid bonding, also called direct bond interconnect (DBI) is a desirable packaging technology to scale the interconnect pitch downward, but there remains a technical need for integrating hybrid bonding interconnect (HBI) components with solder-attach components.

### BRIEF DESCRIPTION OF THE DRAWINGS

FIG. 1A illustrates a side-by-side placement of solder-attach components.
FIG. 1B provides an example multi-die assembly in which the semiconductor dies are hybrid fusion bonded together, in accordance with various embodiments.
FIG. 2 a first exemplary multi-die assembly 200 solution for hybrid solder and solderless die stacking.
FIG. 3 and FIG. 4 provide additional exemplary multi-die assemblies for hybrid solder and solderless die stacking, in accordance with various embodiments.
FIG. 5 illustrates example process steps for a method for hybrid solder and solderless die stacking, in accordance with embodiments described herein.
FIG. 6 provides images to illustrate the process described in FIG. 5.
FIG. 7 is a top view of a wafer and dies that may be included in any of the embodiments disclosed herein.
FIG. 8 is a simplified cross-sectional side view showing an implementation of an integrated circuit on a die that may be included in any of the embodiments disclosed herein.
FIG. 9A-9D are simplified perspective views of example planar, FinFET, gate-all-around, and stacked gate-all-around transistors, as may be implemented in various embodiments.
FIG. 10 is a cross-sectional side view of a microelectronic assembly that may include any of the embodiments disclosed herein.
FIG. 11 is a block diagram of an example electrical device that may include any of the embodiments disclosed herein.

### DETAILED DESCRIPTION

In some scenarios, such as to improve yield, the functionality of a large monolithic die is achieved with multiple smaller chiplets connected together with a high wiring density. One of the important factors determining wiring density is the minimum distance between bumps referred to as an interconnect pitch. The solder-based side-by-side placement of solder-attach components that various multi-die assemblies employ can introduce a long traverse (referred to as an interconnect pitch) for some signals. To advance Moore's law, the interconnect pitch has to scale, and the solder-based interconnects or solder-attach process begins to experience technical problems in the form of failures and faults below about a 25µm pitch.

Hybrid bonding, also called direct bond interconnect (DBI) is a packaging technology that involves bringing together the surfaces of two semiconductor devices under applied pressure and/or at elevated temperature, generally as a die stacking solution, resulting in dielectric-to-dielectric bonding and metal-to-metal bonding. HBI advantageously enables "small" pitches (defined herein as a pitch less than 10 microns +/- 10%, and in some cases, the pitch is less than 1 micron +/- 10%). However, for a variety of reasons, there are many components that remain solder-attach components, having solder-based interconnects. Therefore, while HBI is a desirable packaging technology to stack die and scale the interconnect pitch downward, there remains a technical need for integrating hybrid bonding interconnect (HBI) components with solder-attach components. Said differently, there is a need for hybrid solder and solderless die stacking architectures and methods for making the same.

Embodiments disclosed herein propose a technical solution to the above-described technical problems in the form of methods and architectures for hybrid solder and solderless die stacking. Proposed embodiments create a HBI die complex with two or more semiconductor dies, and stack a solder-attach component, such as a DRAM or high bandwidth memory (HBM) on the HBI die complex. These concepts are developed in more detail below.

Example embodiments are hereinafter described in conjunction with the following drawing figures, wherein like numerals denote like elements. Figures are not necessarily to scale but may be relied on for spatial orientation and relative positioning of features. As may be appreciated, certain terminology, such as "ceiling" and "floor", as well as "upper,", "uppermost", "lower," "above," "below," "bottom," and "top" refer to directions based on viewing the Figures to which reference is made. Further, terms such as "front," "back," "rear,", "side", "vertical", and "horizontal" may describe the orientation and/or location of portions of the component within a consistent but arbitrary frame of reference which is made clear by reference to the text and the associated Figures describing the component under discussion. Such terminology may include the words specifically mentioned above, derivatives thereof, and words of similar import.

The following detailed description is not intended to limit the application and use of the disclosed technologies. It may be evident that the novel embodiments can be practiced without every detail described herein. For the sake of brevity, well-known structures and devices may be shown in block diagram form to facilitate a description thereof.

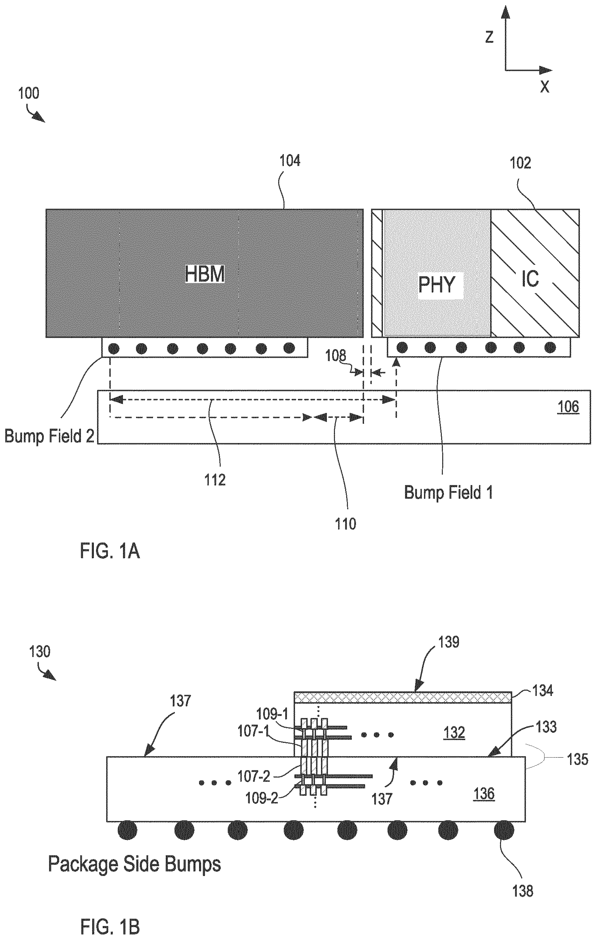

FIG. 1A illustrates (using a cross-sectional image, or Z-X frame of reference) a technical problem presented by side-by-side placement of solder-attach components. In the illustration, IC die 102 has bump field 1 and a second die, such as a high bandwidth memory (HBM) 104 has a bump field 2. Dedicated circuitry indicated as PHY in the illustration provides translational support between the input/output (I/O) speeds and voltages of the components (IC die 102 and HBM 104). Often, a component 106 is used to scale routing and interconnects between the components (IC die 102 and HBM 104); the component 106 can be an organic or silicon interposer, organic substrate or a silicon bridge, embedded in a substrate (not shown).

As is illustrated in FIG. 1A, these side-by-side placements can incur a long traverse for some signals. For example, the traverse 112 combines a distance 108 between the dies, plus a distance to the edge 110 of the bump field, plus, at the maximum distance, a distance across the bump field designated bump field 2. Scaling of interconnect pitch can help lower the traverse distance which can be enabled by hybrid bonding. However due to side-by-side placement the traverse path due to 110 and bump field 2 cannot be avoided.

In FIG. 1B, the exemplary semiconductor die 132 includes an "active," or chiplet region 134 of front-end-of-line (FEOL) semiconductor processing and structures wherein the individual devices (e.g., integrated circuitry, such as, transistors, capacitors, resistors, etc.) are patterned in the semiconductor substrate or layer. The chiplet region 134 is overlaid with layers of dielectric and/or oxides interspersed with conductive interconnects (vias and traces), building up to an HB surface 133 (note, that the chiplet/die 132 is flipped, so "building up to" is relative, and the HB surface 133 appears as a lower surface of die 132 in multi-die assembly 130). At least one hybrid bond conductive contact 107-1 is exposed at the HB surface 133. Likewise, the die 136 is similarly constructed and has an HB surface 137 with at least one corresponding hybrid bond conductive contact 107-2. The hybrid bond conductive contacts 107-1 and 107-2 (shortened herein to conductive contacts 107) are conductive, generally comprising a metal, such as copper (Cu). The conductive contacts 107 are surrounded by (in a plan view) dielectric material at their respective HB surface. In other words, there is dielectric material adjacent to metal/Cu contacts 107.

The die 132 is hybrid bonded to die 136. Accordingly, at the HB interface 135: insulating or dielectric material of die 132 is bonded to the insulating or dielectric material of die 136 (e.g., SiOx to SiOx, SiOxNy to SiOxNy, or the like) and conductive contacts 107-1 from die 132 are direct metal bonded to respective conductive contacts 107-2 from die 136, and there is no solder material at this HB interface 135. At least one conductive contact 107-1 is coupled to the integrated circuitry of the chiplet region 134, e.g., via a through silicon via (TSV) 109-1, and exposed at the HB hybrid bonding surface 133, as shown. In various aspects of the disclosure, the conductive contacts 107-1 are to provide an electrical path from respective nodes in the chiplet region 134 through the bonding layers, and are exposed at the (lower surface, in the illustration) surface that is HB to the HB surface 137 of semiconductor die 136. In various applications, the multi-die assembly 130 is created in which the semiconductor die 134 is flipped and HB hybrid bonded to the semiconductor die 136.

In some embodiments, the semiconductor die 136 includes active integrated circuitry; in other embodiments, the semiconductor die 136 is passive (e.g., referred to as a "base die"), having therein routing and vias to support interconnections and power routing therethrough (e.g., via a TSV or through dielectric via (TDV 109-2). In various embodiments, the bottom surface (in the illustration) of the semiconductor die 136 has a plurality of solder balls or bumps that are electrically connected to routing, such as the TDVs 109-2, within. By implementing the above-described hybrid bonding interconnect (HBI) architectures on the first semiconductor die 132 and the second semiconductor die 136, a multi-die assembly 130 can be created with the hybrid bonding procedure. In some embodiments, the multi-die assembly 130 may be referred to as at least part of a "HBI complex."

As mentioned above, a technical challenge is presented when the HBI complex (e.g., the multi-die assembly 130) is to be assembled with a solder-attach component, such as the high bandwidth memory, HBM 104. Accordingly, aspects of the present disclosure propose technical solutions. In the following figures, the HB interface described in connection with FIG. 1B has been simplified to a patterned layer HBI 207/307/407.

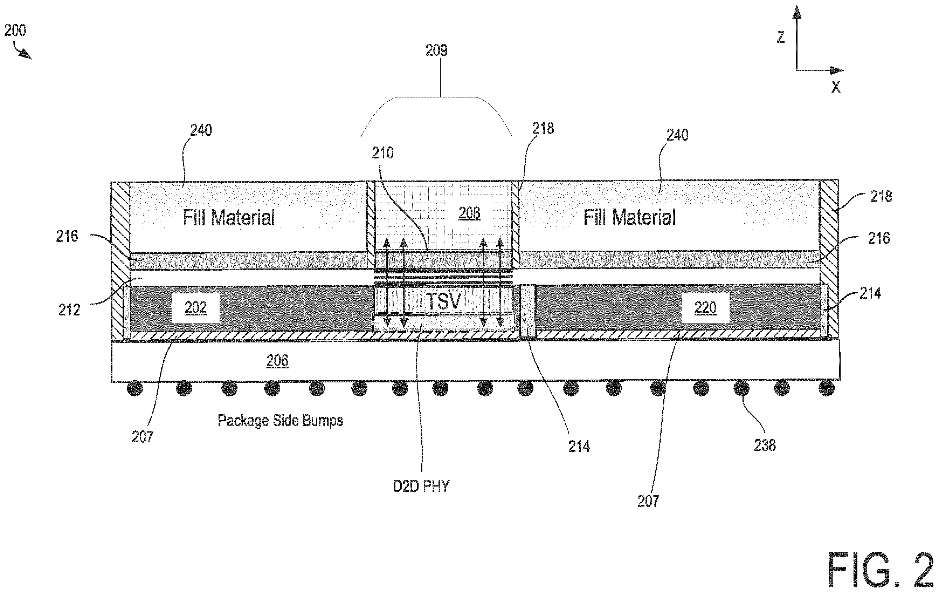

FIG. 2 illustrates a first exemplary multi-die assembly 200 solution for hybrid solder and solderless die stacking. The multi-die assembly 200 is analogous to the multi-die assembly 130, with the addition of solder-attach component 208. The semiconductor die 202 is hybrid bonded on its bottom surface to the upper surface of the base die 206, as indicated with HBI 207 (in assembled multi-die assemblies 200, there may be more than one semiconductor die HBI bonded to the base die 206, as illustrated with the second semiconductor die 220).

Advantageously, embodiments enable solder and solderless die stacking, as illustrated, by attaching the solder bump field 210 of the solder-attach component 208 on an upper surface of semiconductor die 202. In support of this, embodiments the semiconductor die 202 may be modified as described herein. As shown, region 209 of the semiconductor die 202 upper surface is configured with through silicon vias (TSVs) to connect component 208 to die 202 via die-to-die physical interface (D2D PHY), as shown. Vertical double-arrows indicate the presence of operational electrical pathways for signals traveling between the base die 206, through the semiconductor die 202, to the solder-attach component 208. As before, in various embodiments, the solder-attach component 208 is an HBM, DRAM or a solder based chiplet.

In some embodiments, an optional redistribution layer (RDL) 212 is included between the upper surface of the semiconductor die 202 and the solder bump field 210 of the solder-attach component 208. The optional RDL 212 can comprise one or more dielectric layers interleaved with one or more layers of conductive routing and vias, as is generally understood by those with skill in the art. The optional RDL 212 is depicted white with some horizontal lines. Signal communication between and among the solder-attach component 208, the semiconductor die 202, and the base die 206 may employ the optional RDL 212 in embodiments that implement it.

The stacking capability of embodiments advantageously reduces the size/area of the base die 206 needed, reduces the interconnect length and pitch, and improves performance. Embodiments can be identified with visual inspection, to observe the stacking of the semiconductor die and a solder-attach component, and/or to discover a HBM stacked on and soldered to a HBI complex.

To enable a planar top surface of the multi-die assembly 200, fill material is employed. In various embodiments, the fill material comprises multiple pieces of silicon called structural silicon 240, attached on the upper surface of semiconductor die 202 (and die 220, when present) using a layer of solder bumps 216. Each piece of structural silicon 240 can be a dummy piece or passive piece of silicon i.e., it has no transistors or metal wires in it. In other embodiments, the fill material is instead a metal block (e.g., copper or aluminum) to enhance the heat removal from the die 202 and component 208. In a cross-sectional image of the apparatus multi-die assembly 200, the fill material can be found at the periphery of the solder-attach die 208 and over the semiconductor die 202. The solder bumps 216 can be found above the upper surface of the semiconductor die 202 and below the fill material. In a top-down view, a surface area of the solder-attach die 208 is smaller than a surface area of the semiconductor die 202, and external to the solder-attach die 208, the upper surface of the semiconductor die 202 has overlaid thereon a solder bumps 216 layer and a layer comprising fill material. The optional RDL 212, when implemented, is extended across the entire upper surface of the one or more semiconductor dies 202/220, beneath the layer of solder bumps 216. Thus, the multi-die assembly 200 is an apparatus illustrating an exemplary architecture for hybrid solder and solderless die stacking.

In the finished multi-die assembly/apparatus, there may be an oxide or other dielectric 214 around the perimeter of the semiconductor dies 202/220. A mold compound 218 may enclose or surround the multi-die assembly (e.g., surround the components (202, 208, 220)) on the base die 206, and the package side bumps 238 may be soldered onto an organic substrate printed circuit board in a device or more complex system.

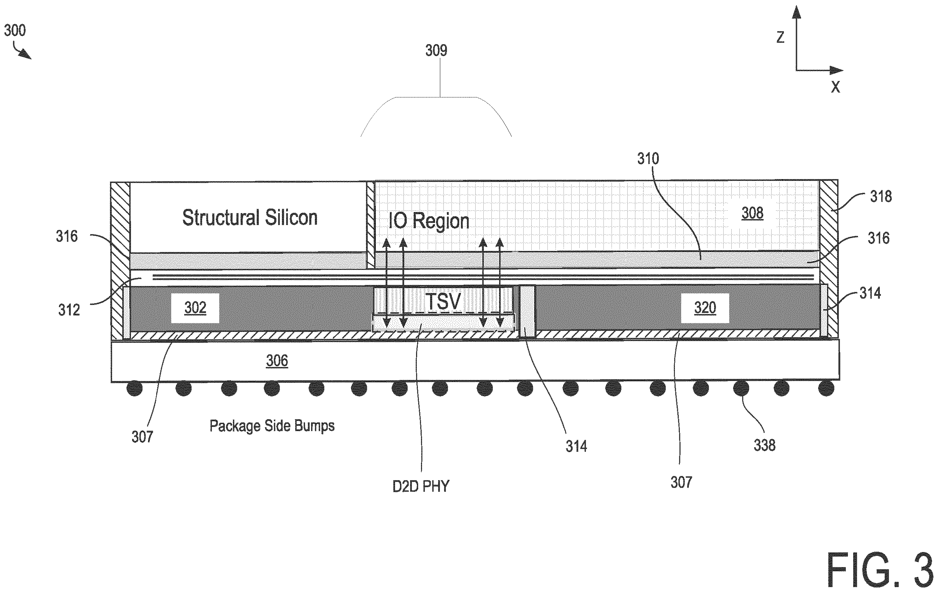

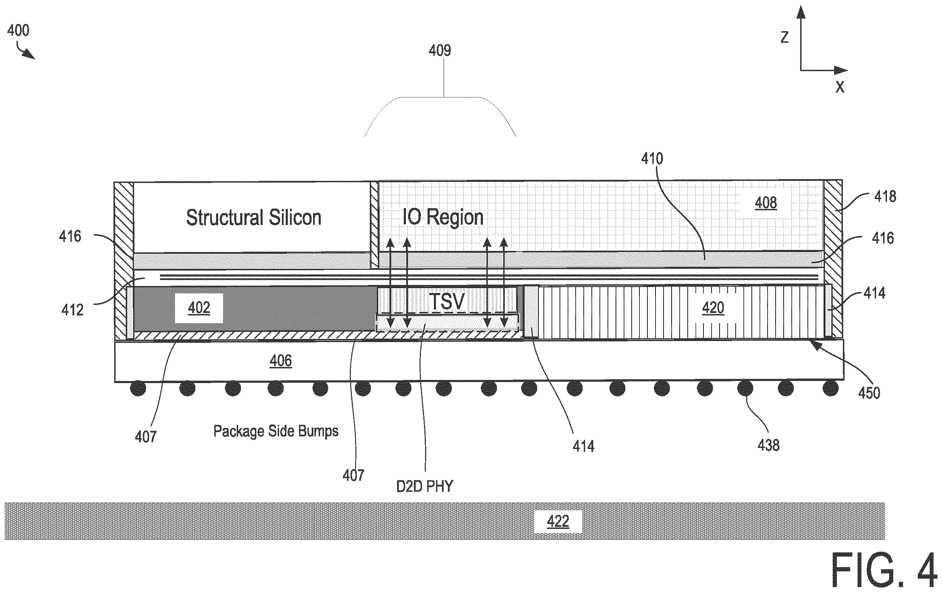

FIG. 3 and FIG. 4 illustrate additional exemplary multi-die assembly solutions for hybrid solder and solderless die stacking, as may be implemented in various packages and devices. Thermal, electrical and design considerations may inform an architectural decision between the embodiments of FIG. 2, FIG. 3, and FIG. 4. In comparing FIG. 2 with FIG. 3 and FIG. 4, the following objects are analogous: semiconductor dies 202/302/402, base dies 206/306/406, solder-attach components (208/308/408), and solder bump fields 210/310/410; also, the hybrid bonding indicated with HBI 207/307/407, that the region 209/309/409 in the first semiconductor die 202/302/402, is where the upper surface is configured with through silicon vias (TSVs) above a suitable die to die physical interface (D2D PHY), as shown; that vertical double-arrows indicate the presence of operational electrical pathways for signals traveling between the base die 206/306/406, through the semiconductor die 202/302/402, to the solder-attach component 208/308/408, optional redistribution layer (RDL) 212/312/412, solder bumps 216/316/416, oxide 214/314/414, fill material, mold 218/318/418, and package side bumps 238/338/448.

In FIG. 3, embodiment 300, the solder-attach component 308 can represent one or more stacked HBMs and/or system on chips (SOCs) in a 3D die complex, as illustrated. In an embodiment, semiconductor die 302 is active, and semiconductor die 320 is passive. In another embodiment, semiconductor die 302 is passive.

In a variation shown in FIG. 4, embodiment 400 the passive semiconductor die 420 may utilize through dielectric vias (TDVs) that punch through the oxide 414 layer of the die complex and land on pads on the base die 406 (arrow 450 indicates the TDVs having access to an upper surface of the base die 408, where individual TDVs land on respective pads of the base die 408). Pitch translation from the TDVs to the high density HBM micro-bump pattern could be completed on RDL(s) 416.

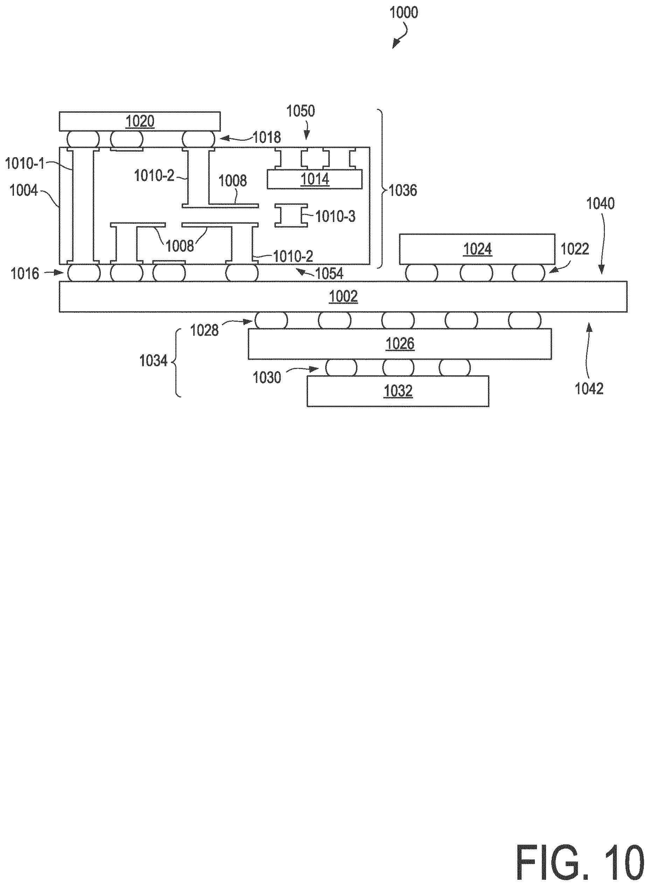

As illustrated in FIG. 4, any of the embodiments of apparatus' 200, 300, and 400 may further be assembled onto an organic substrate or printed circuit board (PCB) 422 in a package or device (see, e.g., FIG. 10, the circuit board 1002) . One or more additional integrated circuit (IC) die may also be attached to the organic substrate/PCB/ circuit board 1002, and the entire silicon complex can be encapsulant with a mold or polymer underfill material. Other encapsulants can comprise a dielectric materials, metal, ceramic, plastic, or a combination thereof. Additionally, a thermal management solution (not shown) comprising a cooling component such as a vapor chamber, heat pipe, heat sink, or liquid-cooled cold plate may be attached to a multi-die package. As part of a thermal management solution, a thermal conduction layer interface material (TIM) may be located over the die. The TIM can be any suitable material, such as a silver particle-filled thermal compound, thermal grease, phase change materials, indium foils, or graphite sheets. The thermal management solution can be a conformal solution that accommodates differences in heights of the integrated circuit dies for which the thermal management solution provides cooling. For example, a thermal management solution can comprise a substantially planar cooling component with TIMs of varying thickness between the cooling component and the integrated circuit dies. In another example, the cooling component is non-planar, and the profile of the cooling component can vary with the thickness of the integrated circuit dies for which the cooling component provides cooling. In such embodiments, the TIM can be of substantially uniform thickness between the cooling component and the integrated circuit dies of varying thicknesses. Thermal management solutions can also include an integrated heat spreader.

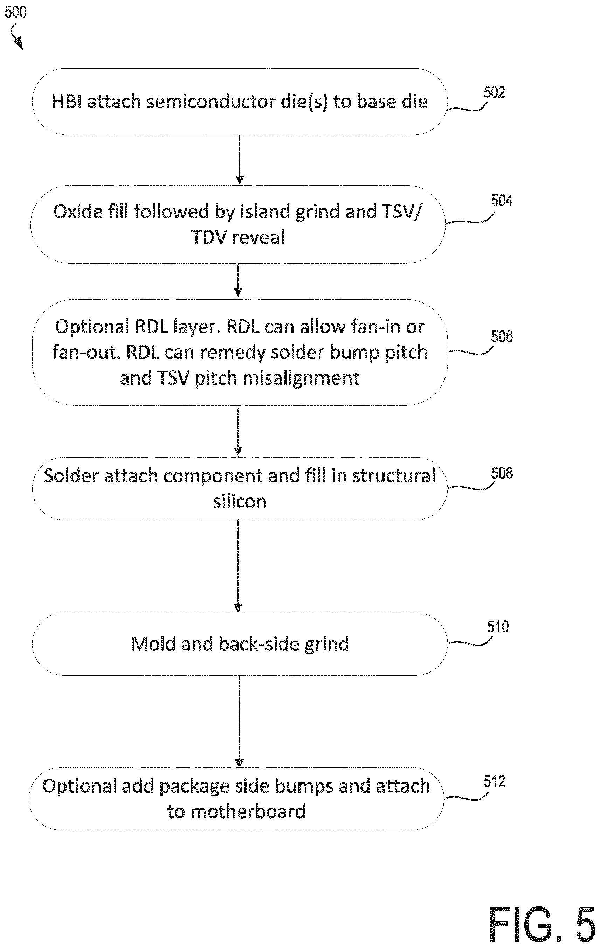

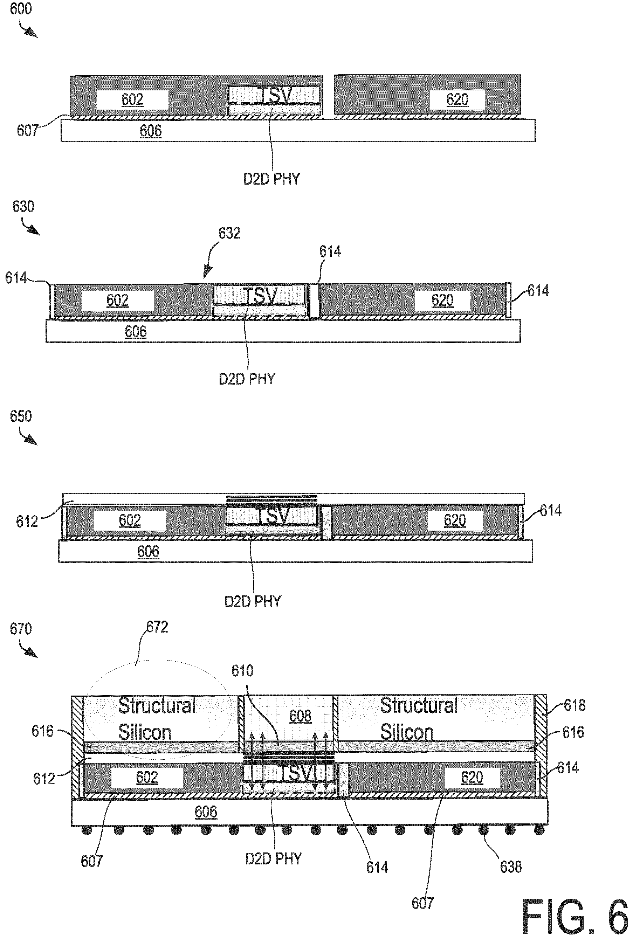

FIG. 5 is a method for hybrid solder and solderless die stacking, in accordance with embodiments described herein, and FIG. 6 provides images in support of the tasks described in FIG. 5. At 502, one or more semiconductor dies (602, 620) are hybrid bonded 607 to the base die 606, thereby creating a HBI complex 600. The semiconductor die 602 has the TSVs and the D2D PHY, as described above. At 504, an oxide 614 or other dielectric is used to fill in gaps between the semiconductor dies on the base die 606. The oxide 614 may comprise silicon dioxide or organic mold. The oxide 614 is then ground down to a planarized surface 632 with the TSVs (and/or TDVs, depending on the embodiment) revealed, see embodiment 630. At 506 one or more optional RDLs 612 can be implemented as one or more layers overlaid on the embodiment 630 to thereby create embodiment 650. RDL 612 can remedy a misalignment between the solder bump locations on the solder-attach component and the TSVs in the semiconductor die 602. The RDL 612 can also allow fan-in or fan-out of signals in the conductive traces.

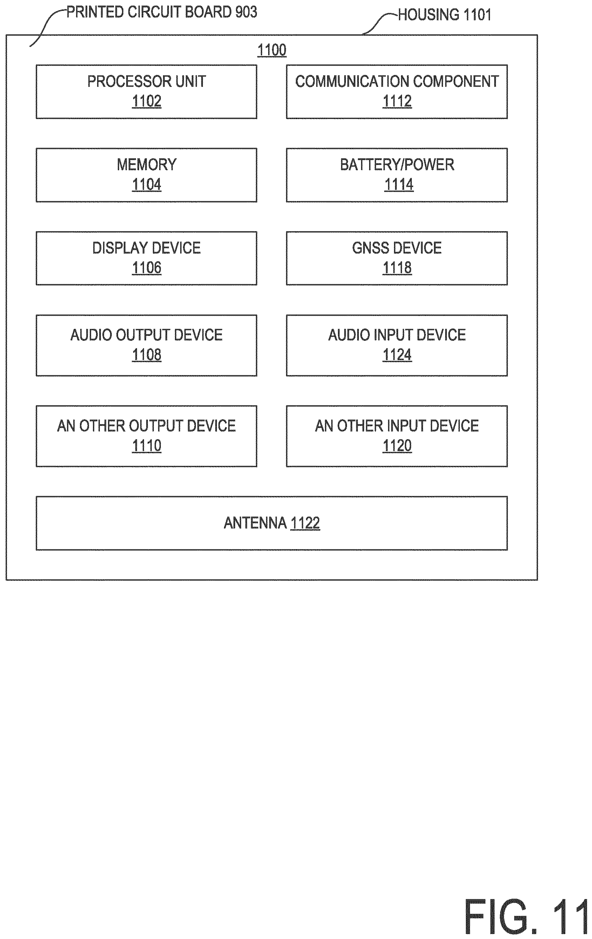

At 508, the solder-attach component 608 is soldered via solder bumps 610 to the embodiment 650, thereby creating a hybrid solder and solderless stacked die complex. At 508 gaps 672 are identified and filled. Gaps manifest when the surface area of the semiconductor die 602/620 and/or base die 606 are larger than the surface area of the solder-attach component 608. The gaps may be filled by attaching the fill material (structural silicon or the metal blocks with solder bumps 616. At 510, the embodiment 670 may be molded and subjected to backside grind, and at 512, the embodiment may optionally have package side bumps added and may further be attached to an organic substrate or printed circuit board (PCB). The embodiment 670 may be further utilized in a microelectronic assembly such as is shown in FIG. 10, and/or in a device as shown in FIG. 11.

Thus, methods and architectures for hybrid solder and solderless die stacking have been described. The following description and associated figures provide more detail for components referenced hereinabove.

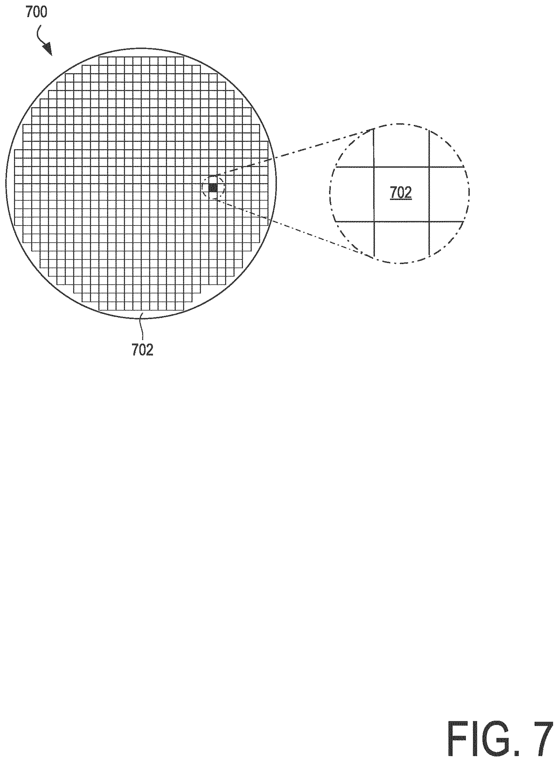

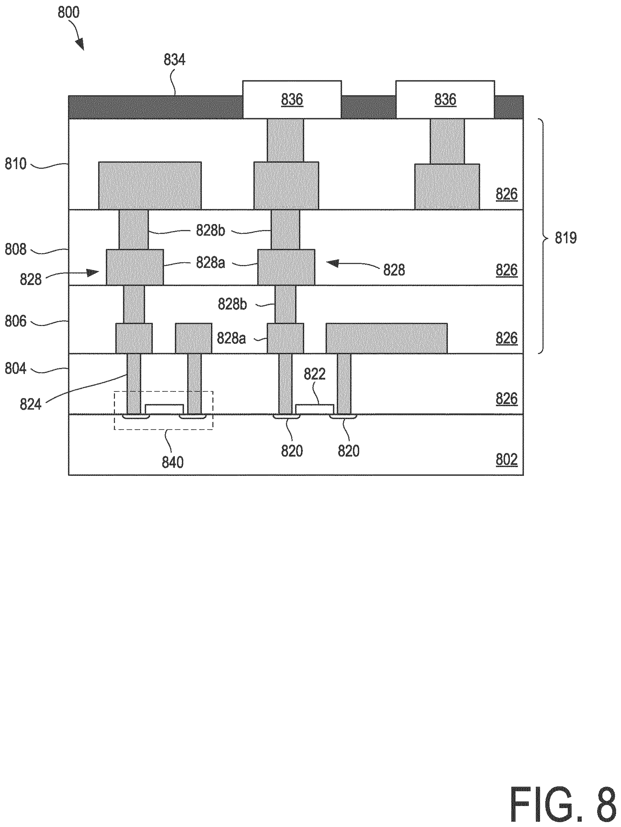

FIG. 7 is a top view of a wafer 700 and dies 702 that may be included in any of the embodiments disclosed herein. The wafer 700 may be composed of semiconductor material and may include one or more dies 702 formed on a surface of the wafer 700. After the fabrication of the integrated circuit components on the wafer 700 is complete, the wafer 700 may undergo a singulation process in which the dies 702 are separated from one another to provide discrete "chips" or destined for a packaged integrated circuit component. The individual dies 702, comprising an integrated circuit component, may include one or more transistors (e.g., some of the transistors 840 of FIG. 8, discussed below), supporting circuitry to route electrical signals to the transistors, passive components (e.g., signal traces, resistors, capacitors, or inductors), and/or any other integrated circuit components. In some embodiments, the wafer 700 or the die 702 may include a memory device (e.g., a random access memory (RAM) device, such as a static RAM (SRAM) device, a magnetic RAM (MRAM) device, a resistive RAM (RRAM) device, a conductive-bridging RAM (CBRAM) device, etc.), a logic device (e.g., an AND, OR, NAND, or NOR gate), or any other suitable circuit element. Additionally, multiple devices may be combined on a single die 702. For example, a memory array formed by multiple memory devices may be formed on a same die 702 as a processor unit (e.g., the processor unit 1102 of FIG. 11) or other logic that is configured to store information in the memory devices or execute instructions stored in the memory array. In some embodiments, a die 702 may be attached to a wafer 700 that includes other die, and the wafer 700 is subsequently singulated, this manufacturing procedure is referred to as a die-to-wafer assembly technique.

FIG. 8 is a cross-sectional side view of an integrated circuit 800 that may be included in any of the embodiments disclosed herein. One or more of the integrated circuits 800 may be included in one or more dies 702 (FIG. 7). The integrated circuit 800 may be formed on a die substrate 802 (e.g., the wafer 700 of FIG. 7) and may be included in a die (e.g., the die 702 of FIG. 7).

The die substrate 802 may be a semiconductor substrate composed of semiconductor material systems including, for example, n-type or p-type materials systems (or a combination of both). The die substrate 802 may include, for example, a crystalline substrate formed using a bulk silicon or a silicon-on-insulator (SOI) substructure. In some embodiments, the die substrate 802 may be formed using alternative materials, which may or may not be combined with silicon, that include, but are not limited to, germanium, indium antimonide, lead telluride, indium arsenide, indium phosphide, gallium arsenide, or gallium antimonide. Further materials classified as group II-VI, III-V, or IV may also be used to form the die substrate 802. Although a few examples of materials from which the die substrate 802 may be formed are described here, any material that may serve as a foundation for an integrated circuit 800 may be used. The die substrate 802 may be part of a singulated die (e.g., the dies 702 of FIG. 7) or a wafer (e.g., the wafer 700 of FIG. 7).

The integrated circuit 800 may include one or more device layers 804 disposed on the die substrate 802. The device layer 804 may include features of one or more transistors 840 (e.g., metal oxide semiconductor field-effect transistors (MOSFETs)) formed on the die substrate 802. The transistors 840 may include, for example, one or more source and/or drain (S/D) regions 820, a gate 822 to control current flow between the S/D regions 820, and one or more S/D contacts 824 to route electrical signals to/from the S/D regions 820.

The gate 822 may be formed of at least two layers, a gate dielectric, and a gate electrode. The gate dielectric may include one layer or a stack of layers. The one or more layers may include silicon oxide, silicon dioxide, silicon carbide, and/or a high-k dielectric material. The high-k dielectric material may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be conducted on the gate dielectric to improve its quality when a high-k material is used.

The gate electrode may be formed on the gate dielectric and may include at least one p-type work function metal or n-type work function metal, depending on whether the transistor 840 is to be a p-type metal oxide semiconductor (PMOS) or an n-type metal oxide semiconductor (NMOS) transistor. In some implementations, the gate electrode may comprise a stack of two or more metal layers, where one or more metal layers are work function metal layers and at least one metal layer is a fill metal layer. Further metal layers may be included for other purposes, such as a barrier layer.

For a PMOS transistor, metals that may be used for the gate electrode include, but are not limited to, ruthenium, palladium, platinum, cobalt, nickel, conductive metal oxides (e.g., ruthenium oxide), and any of the metals discussed below with reference to an NMOS transistor (e.g., for work function tuning). For an NMOS transistor, metals that may be used for the gate electrode include, but are not limited to, hafnium, zirconium, titanium, tantalum, aluminum, alloys of these metals, carbides of these metals (e.g., hafnium carbide, zirconium carbide, titanium carbide, tantalum carbide, and aluminum carbide), and any of the metals discussed above with reference to a PMOS transistor (e.g., for work function tuning).

In some embodiments, when viewed as a cross-section of the transistor 840 along the source-channel-drain direction, the gate electrode may comprise a U-shaped structure that includes a bottom portion substantially parallel to the surface of the die substrate 802 and two sidewall portions that are substantially perpendicular to the top surface of the die substrate 802. In other embodiments, at least one of the metal layers that form the gate electrode may simply be a planar layer that is substantially parallel to the top surface of the die substrate 802 and does not include sidewall portions substantially perpendicular to the top surface of the die substrate 802. In other embodiments, the gate electrode may comprise a combination of U-shaped structures and planar, non-U-shaped structures. For example, the gate electrode may comprise one or more U-shaped metal layers formed atop one or more planar, non-U-shaped layers.

In some embodiments, a pair of sidewall spacers may be formed on opposing sides of the gate stack to bracket the gate stack. The sidewall spacers may be formed from materials such as silicon nitride, silicon oxide, silicon carbide, silicon nitride doped with carbon, and silicon oxynitride. Processes for forming sidewall spacers are well known in the art and include deposition and etching process steps. In some embodiments, a plurality of spacer pairs may be used; for instance, two pairs, three pairs, or four pairs of sidewall spacers may be formed on opposing sides of the gate stack.

The S/D regions 820 may be formed within the die substrate 802 adjacent to the gate 822 of individual transistors 840. The S/D regions 820 may be formed using an implantation/diffusion process or an etching/deposition process, for example. In the former process, dopants such as boron, aluminum, antimony, phosphorous, or arsenic may be ion-implanted into the die substrate 802 to form the S/D regions 820. An annealing process that activates the dopants and causes them to diffuse farther into the die substrate 802 may follow the ion-implantation process. In the latter process, the die substrate 802 may first be etched to form recesses at the locations of the S/D regions 820. An epitaxial deposition process may then be conducted to fill the recesses with material that is used to fabricate the S/D regions 820. In some implementations, the S/D regions 820 may be fabricated using a silicon alloy such as silicon germanium or silicon carbide. In some embodiments, the epitaxially deposited silicon alloy may be doped in situ with dopants such as boron, arsenic, or phosphorous. In some embodiments, the S/D regions 820 may be formed using one or more alternate semiconductor materials such as germanium or a group III-V material or alloy. In further embodiments, one or more layers of metal and/or metal alloys may be used to form the S/D regions 820.

Electrical signals, such as power and/or input/output (I/O) signals, may be routed to and/or from the devices (e.g., transistors 840) of the device layer 804 through one or more interconnect layers disposed on the device layer 804 (illustrated in FIG. 8 as interconnect layers 806-810). For example, electrically conductive features of the device layer 804 (e.g., the gate 822 and the S/D contacts 824) may be electrically coupled with the interconnect structures 828 of the interconnect layers 806-810. The one or more interconnect layers 806-810 may form a metallization stack (also referred to as an "ILD stack") 819 of the integrated circuit 800.

The interconnect structures 828 may be arranged within the interconnect layers 806-810 to route electrical signals according to a wide variety of designs; in particular, the arrangement is not limited to the particular configuration of interconnect structures 828 depicted in FIG. 8. Although a particular number of interconnect layers 806-810 is depicted in FIG. 8, embodiments of the present disclosure include integrated circuits having more or fewer interconnect layers than depicted.

In some embodiments, the interconnect structures 828 may include lines 828a and/or vias 828b filled with an electrically conductive material such as a metal. The lines 828a may be arranged to route electrical signals in a direction of a plane that is substantially parallel with a surface of the die substrate 802 upon which the device layer 804 is formed. For example, the lines 828a may route electrical signals in a direction in and out of the page and/or in a direction across the page. The vias 828b may be arranged to route electrical signals in a direction of a plane that is substantially perpendicular to the surface of the die substrate 802 upon which the device layer 804 is formed. In some embodiments, the vias 828b may electrically couple lines 828a of different interconnect layers 806-810 together.

The interconnect layers 806-810 may include a dielectric material 826 disposed between the interconnect structures 828, as shown in FIG. 8. In some embodiments, dielectric material 826 disposed between the interconnect structures 828 in different ones of the interconnect layers 806-810 may have different compositions; in other embodiments, the composition of the dielectric material 826 between different interconnect layers 806-810 may be the same. The device layer 804 may include a dielectric material 826 disposed between the transistors 840 and a bottom layer of the metallization stack as well. The dielectric material 826 included in the device layer 804 may have a different composition than the dielectric material 826 included in the interconnect layers 806-810; in other embodiments, the composition of the dielectric material 826 in the device layer 804 may be the same as a dielectric material 826 included in any one of the interconnect layers 806-810.

A first interconnect layer 806 (referred to as Metal 1 or "M1") may be formed directly on the device layer 804. In some embodiments, the first interconnect layer 806 may include lines 828a and/or vias 828b, as shown. The lines 828a of the first interconnect layer 806 may be coupled with contacts (e.g., the S/D contacts 824) of the device layer 804. The vias 828b of the first interconnect layer 806 may be coupled with the lines 828a of a second interconnect layer 808.

The second interconnect layer 808 (referred to as Metal 2 or "M2") may be formed directly on the first interconnect layer 806. In some embodiments, the second interconnect layer 808 may include via 828b to couple the lines 828a/b of the second interconnect layer 808 with the lines 828a of a third interconnect layer 810. Although the lines 828a and the vias 828b are structurally delineated with a line within individual interconnect layers for the sake of clarity, the lines 828a and the vias 828b may be structurally and/or materially contiguous (e.g., simultaneously filled during a dual-damascene process) in some embodiments.

The third interconnect layer 810 (referred to as Metal 3 or "M3") (and additional interconnect layers, as desired) may be formed in succession on the second interconnect layer 808 according to similar techniques and configurations described in connection with the second interconnect layer 808 or the first interconnect layer 806. In some embodiments, the interconnect layers that are "higher up" in the metallization stack 819 in the integrated circuit 800 (i.e., farther away from the device layer 804) may be thicker that the interconnect layers that are lower in the metallization stack 819, with lines 828a and vias 828b in the higher interconnect layers being thicker than those in the lower interconnect layers.

The integrated circuit 800 may include a solder resist material 834 (e.g., polyimide or similar material) and one or more conductive contacts 836 formed on the interconnect layers 806-810. In FIG. 8, the conductive contacts 836 are illustrated as taking the form of bond pads. The conductive contacts 836 may be electrically coupled with the interconnect structures 828 and configured to route the electrical signals of the transistor(s) 840 to external devices. For example, solder bonds may be formed on the one or more conductive contacts 836 to mechanically and/or electrically couple an integrated circuit die including the integrated circuit 800 with another component (e.g., a printed circuit board). The integrated circuit 800 may include additional or alternate structures to route the electrical signals from the interconnect layers 806-810; for example, the conductive contacts 836 may include other analogous features (e.g., posts) that route the electrical signals to external components.

In some embodiments in which the integrated circuit 800 is a double-sided die, the integrated circuit 800 may include another metallization stack (not shown) on the opposite side of the device layer(s) 804. This metallization stack may include multiple interconnect layers as discussed above with reference to the interconnect layers 806-810, to provide electrically conductive paths (e.g., including conductive lines and vias) between the device layer(s) 804 and additional conductive contacts (not shown) on the opposite side of the integrated circuit 800 from the conductive contacts 836.

In other embodiments in which the integrated circuit 800 is a double-sided die, the integrated circuit 800 may include one or more through-silicon vias (TSVs) through the die substrate 802; these TSVs may make contact with the device layer(s) 804, and may provide electrically conductive paths between the device layer(s) 804 and additional conductive contacts (not shown) on the opposite side of the integrated circuit 800 from the conductive contacts 836. In some embodiments, TSVs extending through the substrate can be used for routing power and ground signals from conductive contacts on the opposite side of the integrated circuit 800 from the conductive contacts 836 to the transistors 840 and any other components integrated into the die of the integrated circuit 800, and the metallization stack 819 can be used to route I/O signals from the conductive contacts 836 to transistors 840 and any other components integrated into the die of the integrated circuit 800.

Multiple integrated circuits 800 may be stacked with one or more TSVs in the individual stacked devices providing connection between one of the devices to any of the other devices in the stack. For example, one or more high-bandwidth memory (HBM) integrated circuit dies can be stacked on top of a base integrated circuit die and TSVs in the HBM dies can provide connection between the individual HBM and the base integrated circuit die. Conductive contacts can provide additional connections between adjacent integrated circuit dies in the stack. In some embodiments, the conductive contacts can be fine-pitch solder bumps (microbumps).

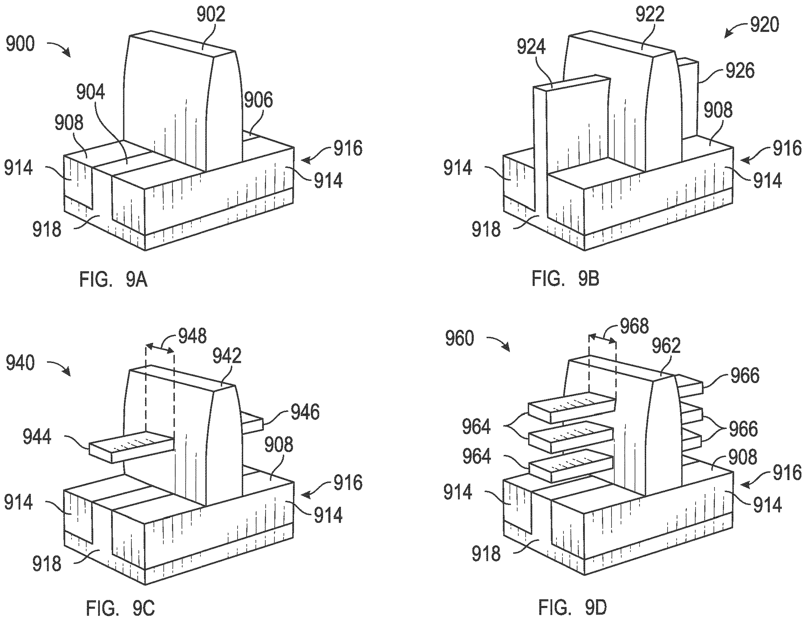

FIGS. 9A-9D are simplified perspective views of example planar, FinFET, gate-all-around, and stacked gate-all-around transistors. The transistors illustrated in FIGS. 9A-9D are formed on a substrate 916 having a surface 908. Isolation regions 914 separate the source and drain regions of the transistors from other transistors and from a bulk region 918 of the substrate 916.

FIG. 9A is a perspective view of an example planar transistor 900 comprising a gate 902 that controls current flow between a source region 904 and a drain region 906. The transistor 900 is planar in that the source region 904 and the drain region 906 are planar with respect to the substrate surface 908.

FIG. 9B is a perspective view of an example FinFET transistor 920 comprising a gate 922 that controls current flow between a source region 924 and a drain region 926. The transistor 920 is non-planar in that the source region 924 and the drain region 926 comprise "fins" that extend upwards from the substrate surface 908. As the gate 922 encompasses three sides of the semiconductor fin that extends from the source region 924 to the drain region 926, the transistor 920 can be considered a tri-gate transistor. FIG. 9B illustrates one S/D fin extending through the gate 922, but multiple S/D fins can extend through the gate of a FinFET transistor.

FIG. 9C is a perspective view of a gate-all-around (GAA) transistor 940 comprising a gate 942 that controls current flow between a source region 944 and a drain region 946. The transistor 940 is non-planar in that the source region 944 and the drain region 946 are elevated from the substrate surface 908.

FIG. 9D is a perspective view of a GAA transistor 960 comprising a gate 962 that controls current flow between multiple elevated source regions 964 and multiple elevated drain regions 966. The transistor 960 is a stacked GAA transistor as the gate controls the flow of current between multiple elevated S/D regions stacked on top of each other. The transistors 940 and 960 are considered gate-all-around transistors as the gates encompass all sides of the semiconductor portions that extend from the source regions to the drain regions. The transistors 940 and 960 can alternatively be referred to as nanowire, nanosheet, or nanoribbon transistors depending on the width (e.g., widths 948 and 968 of transistors 940 and 960, respectively) of the semiconductor portions extending through the gate.

FIG. 10 is a cross-sectional side view of a microelectronic assembly 1000 that may include any of the embodiments disclosed herein. The microelectronic assembly 1000 includes multiple integrated circuit components disposed on a circuit board 1002 (which may be a motherboard, system board, mainboard, etc.). The microelectronic assembly 1000 may include components disposed on a first face 1040 of the circuit board 1002 and an opposing second face 1042 of the circuit board 1002; generally, components may be disposed on one or both faces 1040 and 1042.

In some embodiments, the circuit board 1002 may be a printed circuit board (PCB) including multiple metal (or interconnect) layers separated from one another by layers of dielectric material and interconnected by electrically conductive vias. The individual metal layers comprise conductive traces. Any one or more of the metal layers may be formed in a desired circuit pattern to route electrical signals (optionally in conjunction with other metal layers) between the components coupled to the circuit board 1002. In other embodiments, the circuit board 1002 may be a non-PCB substrate. The microelectronic assembly 1000 illustrated in FIG. 10 includes a package-on-interposer structure 1036 coupled to the first face 1040 of the circuit board 1002 by coupling components 1016. The coupling components 1016 may electrically and mechanically couple the package-on-interposer structure 1036 to the circuit board 1002, and may include solder balls (as shown in FIG. 10), pins (e.g., as part of a pin grid array (PGA), contacts (e.g., as part of a land grid array (LGA)), male and female portions of a socket, an adhesive, an underfill material, and/or any other suitable electrical and/or mechanical coupling structure.

The package-on-interposer structure 1036 may include an integrated circuit component 1020 coupled to an interposer 1004 by coupling components 1018. The coupling components 1018 may take any suitable form for the application, such as the forms discussed above with reference to the coupling components 1016. Although a single integrated circuit component 1020 is shown in FIG. 10, multiple integrated circuit components may be coupled to the interposer 1004; indeed, additional interposers may be coupled to the interposer 1004. The interposer 1004 may provide an intervening substrate used to bridge the circuit board 1002 and the integrated circuit component 1020.

The integrated circuit component 1020 may be a packaged or unpackaged integrated circuit component that includes one or more integrated circuit dies (e.g., the die 702 of FIG. 7, the integrated circuit 800 of FIG. 8) and/or one or more other suitable components.

The unpackaged integrated circuit component 1020 comprises solder bumps attached to contacts on the die. The solder bumps allow the die to be directly attached to the interposer 1004. In embodiments where the integrated circuit component 1020 comprises multiple integrated circuit die, the die can be of the same type (a homogeneous multi-die integrated circuit component) or of two or more different types (a heterogeneous multi-die integrated circuit component). In addition to comprising one or more processor units, the integrated circuit component 1020 can comprise additional components, such as embedded DRAM, stacked high bandwidth memory (HBM), shared cache memories, input/output (I/O) controllers, or memory controllers. Any of these additional components can be located on the same integrated circuit die as a processor unit, or on one or more integrated circuit dies separate from the integrated circuit dies comprising the processor units. These separate integrated circuit dies can be referred to as "chiplets". In embodiments where an integrated circuit component comprises multiple integrated circuit dies, interconnections between dies can be provided by the package substrate, one or more silicon interposers, one or more silicon bridges embedded in the package substrate, or combinations thereof. A packaged multi-die integrated circuit component can be referred to as a multi-chip package (MCP) or multi-chip module (MCM).

The interposer 1004 may spread connections to a wider pitch or reroute a connection to a different connection. For example, the interposer 1004 may couple the integrated circuit component 1020 to a set of ball grid array (BGA) conductive contacts of the coupling components 1016 for coupling to the circuit board 1002. In the embodiment illustrated in FIG. 10, the integrated circuit component 1020 and the circuit board 1002 are attached to opposing sides of the interposer 1004; in other embodiments, the integrated circuit component 1020 and the circuit board 1002 may be attached to a same side of the interposer 1004. In some embodiments, three or more components may be interconnected by way of the interposer 1004.

In some embodiments, the interposer 1004 may be formed as a PCB, including multiple metal layers separated from one another by layers of dielectric material and interconnected by electrically conductive vias. In some embodiments, the interposer 1004 may be formed of an epoxy resin, a fiberglass-reinforced epoxy resin, an epoxy resin with inorganic fillers, a ceramic material, or a polymer material such as polyimide. In some embodiments, the interposer 1004 may be formed of alternate rigid or flexible materials that may include the same materials described above for use in a semiconductor substrate, such as silicon, germanium, and other group III-V and group IV materials. The interposer 1004 may include metal interconnects 1008 and vias 1010, including but not limited to through hole vias 1010-1 (that extend from a first face 1050 of the interposer 1004 to a second face 1054 of the interposer 1004), blind vias 1010-2 (that extend from the first or second faces 1050 or 1054 of the interposer 1004 to an internal metal layer), and buried vias 1010-3 (that connect internal metal layers).

In some embodiments, the interposer 1004 can comprise a silicon interposer. Through-silicon vias (TSV) extending through the silicon interposer can connect connections on the first face of a silicon interposer to an opposing second face of the silicon interposer. In some embodiments, an interposer 1004 comprising a silicon interposer can further comprise one or more routing layers to route connections on a first face of the interposer 1004 to an opposing second face of the interposer 1004.

The interposer 1004 may further include embedded devices 1014, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency devices, power amplifiers, power management devices, antennas, arrays, sensors, and microelectromechanical systems (MEMS) devices may also be formed on the interposer 1004. The package-on-interposer structure 1036 may take the form of any of the package-on-interposer structures known in the art.

The integrated circuit assembly 1000 may include an integrated circuit component 1024 coupled to the first face 1040 of the circuit board 1002 by coupling components 1022. The coupling components 1022 may take the form of any of the embodiments discussed above with reference to the coupling components 1016, and the integrated circuit component 1024 may take the form of any of the embodiments discussed above with reference to the integrated circuit component 1020.

The integrated circuit assembly 1000 illustrated in FIG. 10 includes a package-on-package structure 1034 coupled to the second face 1042 of the circuit board 1002 by coupling components 1028. The package-on-package structure 1034 may include an integrated circuit component 1026 and an integrated circuit component 1032 coupled together by coupling components 1030 such that the integrated circuit component 1026 is disposed between the circuit board 1002 and the integrated circuit component 1032. The coupling components 1028 and 1030 may take the form of any of the embodiments of the coupling components 1016 discussed above, and the integrated circuit components 1026 and 1032 may take the form of any of the embodiments of the integrated circuit component 1020 discussed above. The package-on-package structure 1034 may be configured in accordance with any of the package-on-package structures known in the art.

FIG. 11 is a block diagram of an example electrical device 1100 that may include one or more of the embodiments disclosed herein. For example, any suitable ones of the components of the electrical device 1100 may include one or more of the disclosed embodiments, semiconductor assemblies, package assemblies, microelectronic assemblies 1000, integrated circuit components 1020, integrated circuits 800, integrated circuit dies 702, or structures disclosed herein. A number of components are illustrated in FIG. 11 as included in the electrical device 1100, but any one or more of these components may be omitted or duplicated, as suitable for the application. In some embodiments, some or all the components included in the electrical device 1100 may be attached to one or more motherboards, mainboards, printed circuit boards, or system boards. In some embodiments, one or more of these components are fabricated onto a single system-on-a-chip (SoC) die. In various embodiments, the electrical device 3000 is enclosed by, or integrated with, a housing.

Additionally, in various embodiments, the electrical device 1100 may not include one or more of the components illustrated in FIG. 11, but the electrical device 1100 may include interface circuitry for coupling to the one or more components. For example, the electrical device 1100 may not include a display device 1106, but may include display device interface circuitry (e.g., a connector and driver circuitry) to which a display device 1106 may be coupled. In another set of examples, the electrical device 1100 may not include an audio input device 1124 or an audio output device 1108, but may include audio input or output device interface circuitry (e.g., connectors and supporting circuitry) to which an audio input device 1124 or audio output device 1108 may be coupled.

The electrical device 1100 may include one or more processor units 1102 (e.g., one or more processor units). As used herein, the terms "processor unit", "processing unit" or "processor" may refer to any device or portion of a device that processes electronic data from registers and/or memory to transform that electronic data into other electronic data that may be stored in registers and/or memory. The processor unit 1102 may include one or more digital signal processors (DSPs), application-specific integrated circuits (ASICs), central processing units (CPUs), graphics processing units (GPUs), general-purpose GPUs (GPGPUs), accelerated processing units (APUs), field-programmable gate arrays (FPGAs), neural network processing units (NPUs), data processor units (DPUs), accelerators (e.g., graphics accelerator, compression accelerator, artificial intelligence accelerator), controller crypto processors (specialized processors that execute cryptographic algorithms within hardware), server processors, controllers, or any other suitable type of processor units. As such, the processor unit can be referred to as an XPU (or xPU).

The electrical device 1100 may include a memory 1104, which may itself include one or more memory devices such as volatile memory (e.g., dynamic random access memory (DRAM), static random-access memory (SRAM)), non-volatile memory (e.g., read-only memory (ROM), flash memory, chalcogenide-based phase-change non-voltage memories), solid state memory, and/or a hard drive. In some embodiments, the memory 1104 may include memory that is located on the same integrated circuit die as the processor unit 1102. This memory may be used as cache memory (e.g., Level 1 (L1), Level 2 (L2), Level 3 (L3), Level 4 (L4), Last Level Cache (LLC)) and may include embedded dynamic random-access memory (eDRAM) or spin transfer torque magnetic random-access memory (STT-MRAM).

In some embodiments, the electrical device 1100 can comprise one or more processor units 1102 that are heterogeneous or asymmetric to another processor unit 1102 in the electrical device 1100. There can be a variety of differences between the processor units 1102 in a system in terms of a spectrum of metrics of merit including architectural, microarchitectural, thermal, power consumption characteristics, and the like. These differences can effectively manifest themselves as asymmetry and heterogeneity among the processor units 1102 in the electrical device 1100.

In some embodiments, the electrical device 1100 may include a communication component 1112 (e.g., one or more communication components). For example, the communication component 1112 can manage wireless communications for the transfer of data to and from the electrical device 1100. The term "wireless" and its derivatives may be used to describe circuits, devices, systems, methods, techniques, communications channels, etc., that may communicate data using modulated electromagnetic radiation through a nonsolid medium. The term "wireless" does not imply that the associated devices do not contain any wires, although in some embodiments they might not.

The communication component 1112 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra-mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication component 1112 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication component 1112 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication component 1112 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication component 1112 may operate in accordance with other wireless protocols in other embodiments. The electrical device 1100 may include an antenna 1122 to facilitate wireless communications and/or to receive other wireless communications (such as AM or FM radio transmissions).

In some embodiments, the communication component 1112 may manage wired communications, such as electrical, optical, or any other suitable communication protocols (e.g., IEEE 802.3 Ethernet standards). As noted above, the communication component 1112 may include multiple communication components. For instance, a first communication component 1112 may be dedicated to shorter-range wireless communications such as Wi-Fi or Bluetooth, and a second communication component 1112 may be dedicated to longer-range wireless communications such as global positioning system (GPS), EDGE, GPRS, CDMA, WiMAX, LTE, EV-DO, or others. In some embodiments, a first communication component 1112 may be dedicated to wireless communications, and a second communication component 1112 may be dedicated to wired communications.

The electrical device 1100 may include power supply such as a battery/power circuitry 1114. The battery/power circuitry 1114 may include one or more energy storage devices (e.g., batteries or capacitors) and/or circuitry for coupling components of the electrical device 1100 to an energy source separate from the electrical device 1100 (e.g., AC line power).

The electrical device 1100 may include a display device 1106 (or corresponding interface circuitry, as discussed above). The display device 1106 may include one or more embedded or wired or wirelessly connected external visual indicators, such as a heads-up display, a computer monitor, a projector, a touchscreen display, a liquid crystal display (LCD), a light-emitting diode display, or a flat panel display.

The electrical device 1100 may include an audio output device 1108 (or corresponding interface circuitry, as discussed above). The audio output device 1108 may include any embedded or wired or wirelessly connected external device that generates an audible indicator, such speakers, headsets, or earbuds.

The electrical device 1100 may include an audio input device 1124 (or corresponding interface circuitry, as discussed above). The audio input device 1124 may include any embedded or wired or wirelessly connected device that generates a signal representative of a sound, such as microphones, microphone arrays, or digital instruments (e.g., instruments having a musical instrument digital interface (MIDI) output). The electrical device 1100 may include a Global Navigation Satellite System (GNSS) device 1118 (or corresponding interface circuitry, as discussed above), such as a Global Positioning System (GPS) device. The GNSS device 1118 may be in communication with a satellite-based system and may determine a geolocation of the electrical device 1100 based on information received from one or more GNSS satellites, as known in the art.

The electrical device 1100 may include another output device 1110 (or corresponding interface circuitry, as discussed above). Examples of the other output device 1110 may include an audio codec, a video codec, a printer, a wired or wireless transmitter for providing information to other devices, or an additional storage device.

The electrical device 1100 may include another input device 1120 (or corresponding interface circuitry, as discussed above). Examples of the other input device 1120 may include an accelerometer, a gyroscope, a compass, an image capture device (e.g., monoscopic or stereoscopic camera), a trackball, a trackpad, a touchpad, a keyboard, a cursor control device such as a mouse, a stylus, a touchscreen, proximity sensor, microphone, a bar code reader, a Quick Response (QR) code reader, electrocardiogram (ECG) sensor, PPG (photoplethysmogram) sensor, galvanic skin response sensor, any other sensor, or a radio frequency identification (RFID) reader.

The electrical device 1100 may have any desired form factor, such as a hand-held or mobile electrical device (e.g., a cell phone, a smart phone, a mobile internet device, a music player, a tablet computer, a laptop computer, a 2-in-1 convertible computer, a portable all-in-one computer, a netbook computer, an ultrabook computer, a personal digital assistant (PDA), an ultra-mobile personal computer, a portable gaming console, etc.), a desktop electrical device, a server, a rack-level computing solution (e.g., blade, tray or sled computing systems), a workstation or other networked computing component, a printer, a scanner, a monitor, a set-top box, an entertainment control unit, a stationary gaming console, smart television, a vehicle control unit, a digital camera, a digital video recorder, a wearable electrical device or an embedded computing system (e.g., computing systems that are part of a vehicle, smart home appliance, consumer electronics product or equipment, manufacturing equipment). In some embodiments, the electrical device 1100 may be any other electronic device that processes data. In some embodiments, the electrical device 1100 may comprise multiple discrete physical components. Given the range of devices that the electrical device 1100 can be manifested as in various embodiments, in some embodiments, the electrical device 1100 can be referred to as a computing device or a computing system.

While at least one embodiment has been presented in the foregoing detailed description, it should be appreciated that a vast number of variations exist. It should also be appreciated that the disclosed embodiments are only examples, and are not intended to limit the scope, applicability, or configuration of the disclosure in any way. Rather, the foregoing detailed description will provide those skilled in the art with a convenient road map for implementing the disclosed embodiment embodiments. Various changes can be made in the function and arrangement of elements without departing from the scope of the disclosure as set forth in the appended claims and the legal equivalents thereof.

As used herein, the term "adjacent" refers to layers or components that are in direct physical contact with each other, with no layers or components in between them. For example, a layer X that is adj acent to a layer Y refers to a layer that is in direct physical contact with layer Y. In contrast, as used herein, the phrase(s) "located on" (in the alternative, "located under," "located above/over," or "located next to," in the context of a first layer or component located on a second layer or component) includes (i) configurations in which the first layer or component is directly physically attached to the second layer (i.e., adjacent), and (ii) component and configurations in which the first layer or component is attached (e.g. coupled) to the second layer or component via one or more intervening layers or components.

Similarly, the word "overlaid" is used herein to denote a spatial relationship, being the past tense of overlay, to have been spread across, or superimposed on an object. Overlaid does not imply any particular procedure for placement. If a first layer is overlaid on a second layer, the first layer is also "located on" the second layer, as defined above.

Terms or values modified by the word "substantially" include arrangements, orientations, spacings, or positions that vary plus or minus 20% from the meaning of the unmodified term or value. Terms or values modified by the word "about" include values inclusive of 10% less than the term or value to inclusive of 10% greater than the term or value.

As used herein, the term "electronic component" can refer to an active electronic circuit (e.g., processing unit, memory, storage device, FET) or a passive electronic circuit (e.g., resistor, inductor, capacitor).

As used herein, the term "integrated circuit component" can refer to an electronic component configured on a semiconducting material to perform a function. An integrated circuit (IC) component can comprise one or more of any computing system components described or referenced herein or any other computing system component, such as a processor unit (e.g., system-on-a-chip (SoC), processor core, graphics processor unit (GPU), accelerator, chipset processor), I/O controller, memory, or network interface controller, and can comprise one or more additional active or passive devices such as capacitors, decoupling capacitors, resistors, inductors, fuses, diodes, transformers, sensors, electrostatic discharge (ESD) devices, and memory devices.

A non-limiting example of an unpackaged integrated circuit component includes a single monolithic integrated circuit die (also shortened herein to "die"); the die may include solder bumps attached to contacts on the die. When present on the die, the solder bumps or other conductive contacts can enable the die to be directly attached to a printed circuit board (PCB) or other substrates.

A non-limiting example of a packaged integrated circuit component comprises one or more integrated circuit dies mounted on a package substrate with the integrated circuit dies and package substrate encapsulated in a casing material, such as a metal, plastic, glass, or ceramic. Often the casing includes an integrated heat spreader (IHS); the packaged integrated circuit component often has bumps, leads, or pins attached to the package substrate (either directly or by wires attaching the bumps, leads, or pins to the package substrate) for attaching the packaged integrated circuit component to a printed circuit board (or motherboard or base board) or another component.

As used herein, phrases such as "an embodiment," "various embodiments," "some embodiments," and the like, indicate that some embodiments may have some, all, or none of the features described for other embodiments. "First," "second," "third," and the like describe a common object and indicate different instances of like objects being referred to; unless specifically stated, they do not imply a given sequence, either temporally or spatially, in ranking, or any other manner. In accordance with patent application parlance, "connected" indicates elements that are in direct physical or electrical contact with each other and "coupled" indicates elements that co-operate or interact with each other, coupled elements may or may not be in direct physical or electrical contact. Furthermore, the terms "comprising," "including," "having," and the like, are utilized synonymously to denote non-exclusive inclusions.

As used in this application and the claims, a list of items j oined by the term "at least one of' or the term "one or more of' can mean any combination of the listed terms. For example, the phrase "at least one of A, B or C" can mean A; B; C; A and B; A and C; B and C; or A, B, and C. Likewise, the phrase "one or more of A, B and C" can mean A; B; C; A and B; A and C; B and C; or A, B, and C.

As used in this application and the claims, the phrase "individual of" or "respective of" following by a list of items recited or stated as having a trait, feature, etc. means that all the items in the list possess the stated or recited trait, feature, etc. For example, the phrase "individual of A, B, or C, comprise a sidewall" or "respective of A, B, or C, comprise a sidewall" means that A comprises a sidewall, B comprises sidewall, and C comprises a sidewall.

Theories of operation, scientific principles, or other theoretical descriptions presented herein in reference to the apparatuses or methods of this disclosure have been provided for the purposes of better understanding and are not intended to be limiting in scope. The apparatuses and methods in the appended claims are not limited to those apparatuses and methods that function in the manner described by such theories of operation.

The following examples pertain to additional embodiments of technologies disclosed herein.

### EXAMPLES

Example 1 is an apparatus comprising: a first die; a second die comprising an integrated circuit, the second die on the first die and hybrid bonded to the first die; wherein the second die further comprises an upper surface and a plurality of through silicon vias (TSVs) that are exposed at the upper surface; and a third die soldered to the upper surface of the second die.

Example 2 includes the subject matter of Example 1, further comprising hybrid bond interconnects in the second die and solder bumps on the third die; and wherein the second die further comprises a die-to-die physical interface (D2D PHY) between the hybrid bond interconnects and the solder bumps.

Example 3 includes the subject matter of Example 1 or Example 2, wherein the first die comprises active circuitry.

Example 4 includes the subject matter of Example 1 or Example 2, wherein the first die is passive.

Example 5 includes the subject matter of any one of Examples 1-4, further comprising a redistribution layer (RDL) between the third die and the upper surface of the second die.

Example 6 includes the subject matter of any one of Examples 1-5, further comprising a fill material at a periphery of the third die and over the second die.

Example 7 includes the subject matter of Example 6, wherein the fill material comprises silicon, and further comprising a mold compound between the silicon and the third die.

Example 8 includes the subject matter of Example 1, wherein the fill material comprises metal, and further comprising one or more solder bumps between the fill material and the second die.

Example 9 includes the subject matter of any one of Examples 1-8, wherein the third die is a dynamic random-access memory (DRAM) component.

Example 10 includes the subject matter of any one of Examples 1-8, wherein the third die is a high bandwidth memory (HBM) component.

Example 11 is a multi-die assembly, comprising: a first die comprising an upper surface configured for hybrid bond interconnects; a semiconductor die on the upper surface of the first die and hybrid bonded thereto; and a solder-attach component located on top of the semiconductor die and attached via solder bumps to the semiconductor die; wherein the semiconductor die comprises a plurality of through silicon vias (TSVs), and individual TSVs attach to a respective solder bump.

Example 12 includes the subject matter of Example 11, wherein the semiconductor die further comprises a die-to-die physical interface (D2D PHY) between the hybrid bond interconnects and the solder bumps.

Example 13 includes the subject matter of Example 11, wherein a surface area of the solder-attach component is smaller than a surface area of the semiconductor die, and further comprising: a solder bump layer overlaid on the upper surface of the semiconductor die external to the solder-attach component; and a fill material overlaid on the solder bump layer.

Example 14 includes the subject matter of Example 13, further comprising a second die side-by-side with the semiconductor die on the upper surface of the first die and hybrid bonded thereto.

Example 15 includes the subject matter of Example 14, further comprising: the solder bump layer further overlaid on an upper surface of the second die; and the fill material further overlaid on the solder bump layer overlaid on the second die.

Example 16 includes the subject matter of Example 11, further comprising: a second die side-by-side with the semiconductor die on the upper surface of the first die and hybrid bonded thereto, wherein the second die comprises a plurality of through dielectric vias (TDVs) extending therethrough.

Example 17 includes the subject matter of Example 16, further comprising: a solder bump layer overlaid on the upper surface of the semiconductor die external to the solder-attach component and on an upper surface of the second die; and a fill material overlaid on the solder bump layer overlaid on the second die.

Example 18 is a microelectronic assembly comprising the subject matter of Example 15, further comprising a mold compound surrounding the multi-die assembly.

Example 19 is a method, comprising: stacking an active semiconductor die on a base die; hybrid bonding the active semiconductor die on a base die to thereby create a hybrid bond interconnect (HBI) complex; stacking a high bandwidth memory (HBM) on top of the semiconductor die; soldering the HBM to the semiconductor die to thereby create a hybrid solder and solderless stacked die complex; and filling gaps in the hybrid solder and solderless stacked die complex.

Example 20 comprises the subject matter of Example 19, further comprising overlaying the hybrid solder and solderless stacked die complex with a mold compound.

## Claims

1. An apparatus comprising:
a first die comprising a first surface with a first insulating material and metal contacts therein;
a second die comprising an integrated circuit and a lower surface comprising a second insulating material having therein a plurality of conductive contacts;
the second die on the first die, individual conductive contacts of the plurality of conductive contacts directly bonded to a respective metal contact on the first surface, the first insulating material directly bonded to the second insulating material;
wherein the second die further comprises an upper surface and a region of the upper surface includes a plurality of through silicon vias (TSVs) that are exposed at the upper surface; and
a third die on the upper surface of the second die, the third die solder-attached to the second die via the plurality of TSVs.

2. The apparatus of claim 1, wherein the plurality of conductive contacts are hybrid bond conductive contacts, and further comprising:
solder bumps on the third die;
wherein the second die further comprises a die-to-die physical interface (D2D PHY) between the hybrid bond conductive contacts and the solder bumps.

3. The apparatus of one of the previous claims, further comprising a redistribution layer (RDL) between the third die and the upper surface of the second die.

4. The apparatus of one of the previous claims, further comprising a fill material over the second die at a periphery of the third die and external to the region.

5. The apparatus of claim 4, wherein the fill material comprises silicon, and further comprising a mold compound between the silicon and the third die.

6. The apparatus of claim 5, further comprising one or more additional solder bumps between the silicon and the second die.

7. The apparatus of any one of claims 1-6, wherein the third die is a dynamic random-access memory (DRAM) component.

8. The apparatus of claims 1-6, wherein the third die is a high bandwidth memory (HBM) component.

9. The apparatus of one of the previous claims, wherein a surface area of the third die is smaller than the upper surface of the second die, and further comprising:
a solder bump layer overlaid on the upper surface of the second die external to the third die; and
a fill material overlaid on the solder bump layer.

10. The apparatus of claim 9, further comprising a fourth die side-by-side with the second die on the upper surface of the first die and bonded thereto.

11. The apparatus of claim 10, further comprising:
the solder bump layer further overlaid on an upper surface of the fourth die; and
the fill material further overlaid on the solder bump layer overlaid on the fourth die.

12. A method, comprising:
stacking an active semiconductor die with a first hybrid bond interface on a base die with a second hybrid bond interface;
bonding metal in the first hybrid bond interface to metal in the second hybrid bond interface;
bonding dielectric in the first hybrid bond interface to dielectric in the second hybrid bond interface to thereby create a hybrid bond interconnect (HBI) complex;
stacking a high bandwidth memory (HBM) on an upper surface of the active semiconductor die; and
soldering the HBM to a region of the upper surface of the active semiconductor die to thereby create a hybrid stacked die complex.

13. The method of claim 12,
wherein:
the region of the upper surface of the active semiconductor die comprises a plurality of through silicon vias (TSVs);
the HBM occupies the region and is electrically connected to the plurality of TSVs; and
further comprising overlaying the hybrid stacked die complex with a mold compound.

14. The method of claim 13, wherein individual TSVs of the plurality of TSVs provide an electrical path to a die-to-die physical interface (D2D PHY) in the active semiconductor die.

15. The method of claim 14, further comprising filling a gap around the HBM on the upper surface of the active semiconductor die with a structural silicon material or structural metal material.
